# EUROPÄISCHE PATENTANMELDUNG

(11) **EP 4 092 855 A1**
(43) Veröffentlichungstag der Anmeldung: **23.11.2022**
(21) Anmeldenummer: 22173431.2
(22) Anmeldetag: 16.05.2022
(51) Int. Cl.: H02H 3/087, H02H 3/24, H02H 7/26

(54) **ELEKTRONISCHER SICHERUNGSSCHALTKREIS**

(30) Priorität: 20.05.2021 DE 102021113107
(71) Anmelder: Lisa Dräxlmaier GmbH, 84137 Vilsbiburg (DE)
(72) Erfinder: Wortberg, Michael, 84405 Dorfen (DE)

(57) **Zusammenfassung**

Die Offenbarung betrifft einen elektronischer Sicherungsschaltkreis zum Absichern eines mehrkanaligen elektronischen Stromverteilers. Der elektronische Sicherungsschaltkreis umfasst: einen Treiberschaltkreis für jeden Kanal des elektronischen Stromverteilers, der ausgebildet ist, einen elektronischen Schalter eines entsprechenden Kanals anzusteuern, einen bestimmten Zustand einzunehmen; eine Mikrocontroller-Schnittstelle, welche ausgebildet ist, eine Anweisung zum Einstellen des Zustands des elektronischen Schalters eines entsprechenden Kanals von einem Mikrocontroller zu empfangen, wobei der Treiberschaltkreis des entsprechenden Kanals ausgebildet ist, den Zustand des elektronischen Schalters des entsprechenden Kanals entsprechend der Anweisung von dem Mikrocontroller einzustellen; und einen Sicherheits-Schaltkreis zum Erkennen einer Fehlfunktion in dem Mikrocontroller und/oder dem elektronischen Stromverteiler. Der Treiberschaltkreis eines jeden Kanals ist ausgebildet, bei einer erkannten Fehlfunktion in dem Mikrocontroller und/oder dem Stromverteiler den Zustand des elektronischen Schalters des entsprechenden Kanals entsprechend einem kanalspezifisch vorkonfigurierten Sicherheitszustand einzustellen.

## Beschreibung

Die Offenbarung betrifft einen elektronischen Sicherungsschaltkreis zum Absichern eines mehrkanaligen elektronischen Stromverteilers und ein entsprechendes Verfahren zum Absichern eines mehrkanaligen elektronischen Stromverteilers. Insbesondere betrifft die Offenbarung ein "Mixed Signal" Front-End für einen Mikrocontroller zum FUSI (Funktionale Sicherheit) tauglichen elektrischen Schalten und Absichern.

In konventionellen Fahrzeugen erfolgt das Absichern im Bordnetz über Schmelzsicherungen. Diese haben die Eigenschaft, dass sie Leitungen schützen können, allerdings nicht rückwirkungsfrei. Der Strom, der notwendig ist eine Sicherung zum Auslösen zu bringen kann so hoch sein, dass die Spannung im Bordnetz einbricht und sicherheitskritische Funktionen wegen Unterspannung ausfallen. Die Rückwirkungsfreiheit (bezüglich "Disconnect Overload", d.h. Überlastabschaltung) von nicht sicherheitskritischen Lastpfaden erbt daher die Integritätsanforderungen der "Provide Supply", d.h. Bereitstellung der Stromversorgung, für sicherheitskritische Funktionen. Es muss also die Propagation bzw. Verbreitung von Fehlern ausgehend von QM (Qualitätsmanagement)-Bordnetzteilnehmern mit der Klassifikation ASIL B ("Automotive Safety Integrity Level B" entsprechend einer empfohlenen Ausfallwahrscheinlichkeit von kleiner 10⁻⁷ pro Stunde für die Funktion, bzw. das Sicherheitsziel) vermieden werden.

In der direkten Versorgung von sicherheitskritischen Funktionen kommt direkt die technische Sicherheitsanforderung nach der "Provide Supply"-Anforderung zum Tragen. Hier darf die Verbindung in einem elektronischen Stromverteiler nicht unplausibel unterbrochen werden.

Die geforderte Integrität für sicherheitskritische Funktionen ist typischerweise ASIL D ("Automotive Safety Integrity Level D" entsprechend einer geforderten Ausfallwahrscheinlichkeit von kleiner 10⁻⁸ pro Stunde für die Funktion, bzw. für das Sicherheitsziel). Die ASIL D wird für zwei redundante Versorgungszweige auf zweimal ASIL B(D) dekomponiert.

Es ist eine Aufgabe der Erfindung, ein Konzept für das Absichern im Bordnetz von Fahrzeugen zu schaffen, das die oben beschriebenen Sicherheitsanforderungen erfüllt.

Insbesondere ist es eine Aufgabe der Erfindung, einen elektronischen Sicherungsschaltkreis zu entwerfen, der ein elektronisches Schalten und Absichern mit der Integrität ASIL B unterstützt.

Diese Aufgabe wird durch die Gegenstände mit den Merkmalen nach den unabhängigen Ansprüchen gelöst. Vorteilhafte Ausführungsformen sind Gegenstand der abhängigen Ansprüche, der Beschreibung und der Zeichnungen.

Die Offenbarung basiert auf der Idee, einen elektronischen Sicherheitsschaltkreis (in dieser Offenbarung auch als "Electronic Fuse Asic" (EFASic) bezeichnet) als Mixed-Signal Front-End eines Mikrocontrollers (µC) zu nutzen, um eine schnelle Ansteuerung eines elektronischen Stromverteilers zu implementieren, welche den geforderten Sicherheitsanforderungen genügt.

Das Electronic Fuse Asic (EFASic) kann als Mixed Signal Frontend zu einem µC mit DSP Kernel oder zumindest ALU genutzt werden. Mit diesem Mixed Signal Frontend kann ein µC mit einem EFASic z.B. 4 MOSFETs (Metall-Oxid-Halbleiter Feldeffekttransistoren) oder allgemein elektronische Schalter ansteuern. Das EFASic kann mit dem µC über ein SPI (serielles Peripherie-Interface) oder einen ähnlichen Prozessorbus verbunden sein. Über einen µC können somit n x 4, z.B. 80 Kanäle mit MOSFETs angesteuert werden. Als MOSFETs können typischerweise Trench-FETs verwendet werden, die einen niedrigen RDSon, d.h. Drain-Source Widerstand im eingeschalteten Zustand (im Vergleich zu Smart-FETs) aufweisen.

Ein solches Electronic Fuse Asic (EFASic) lässt sich einfach und kostengünstig implementieren, da zum einen MOSFETs mit sehr niedrigem RDSon verfügbar sind und ihre Kosten pro Strom-Tragfähigkeit stetig abnimmt, und zum anderen die Rechenleistung von modernen Mikrocontrollern immer weiter zunimmt und kostengünstige Mikrocontroller mit dedizierten DSP (Digitale Signalprozessor) Kernels zur Verfügung stehen.

Der hier vorgestellte elektronische Sicherheitsschaltkreis bzw. das Mixed Signal Front-End ASIC (EFASic) zum µC unterstützt elektronisches Schalten und Absichern mit der Integrität ASIL B.

Im Einzelnen werden die folgenden Anforderungen unterstützt:
A) Anforderung bezüglich "Disconnect Overload" bzw. Überlastabschaltung: Abschalten hoher transienter Überströme (mit hohem Rückwirkungspotential); Abschalten stationärer (langsamer) Überlastsituationen; Abschalten bei Unterspannung im Bordnetz; Verfügbarkeit der Versorgung gemäß Klemmenstatus.
B) Anforderung an einen Kanal eines elektronischen Stromverteilers bezüglich Rückwirkungsfreiheit von QM-Bordnetzteilnehmern, ASIL B, Safe State OFF, EOTI ("Emergency Operation Time Interval") für einen Fahrzyklus: Ansteuerung schneller Schaltelemente, z.B. MOSFETs über Gate-Treiber; Schnelle Erkennung und Abschaltung transienter Strom-Überlast oder Kurzschluss; Erkennen und Abschalten langsamer Überlasten; Erkennen und Abschalten bei Unterspannung; Diagnose und Verfügbarkeit der Erkennungsmechanismen für das Abschalten stationärer (langsamer) Überlastsituationen, das Abschalten bei Unterspannung im Bordnetz und die Verfügbarkeit der Versorgung gemäß Klemmenstatus gemäß ASIL B; Diagnose und Verfügbarkeit der Abschaltmechanismen für das Abschalten stationärer (langsamer) Überlastsituationen, das Abschalten bei Unterspannung im Bordnetz und die Verfügbarkeit der Versorgung gemäß Klemmenstatus gemäß ASIL B; Einnahme des sicheren Zustandes OFF bei Fehler.
C) Anforderung an die verfügbare Versorgung von kritischen Funktionen: Ansteuerung des Schaltelements, z.B. MOSFETs über Gate-Treiber; MOSFETs Durchschalten gemäß Klemmenstatus; MOSFETs Abschalten bei Überstrom; Diagnose und Verfügbarkeit der Durchschalt-Mechanismen für das Abschalten stationärer (langsamer) Überlastsituationen gemäß ASIL B; Diagnose und Vermeidung von Falschabschaltung der Mechanismen für das Abschalten bei Unterspannung im Bordnetz gemäß ASIL B; Einnahme des sicheren Zustandes ON bei Fehler.

Mit dem hier vorgestellten elektronische Sicherheitsschaltkreis bzw. EFASic können die folgenden Vorteile realisiert werden: Ausnutzen der zur Verfügung stehenden Ressourcen moderner µC und damit Implementierung kostengünstiger EFASic ohne µC Kernel oder Recheneinheit; Ausnutzen der sehr niedrigen RDSON und damit des günstigen Kosten pro Flächenverhältnis der MOSFETs; sehr hohe Ströme sind über eine Parallelschaltung von MOSFETs realisierbar; Einsparungen im Kühlkonzept, da nur circa 50% bis 30% der Abwärme erzeugt wird im Vergleich zu einzelnen MOSFET; Strommessung ohne Shunt womit Kosteneinsparungen und Verlustwärmeeinsparungen realisierbar sind.

Gemäß einem ersten Aspekt wird die oben beschriebene Aufgabe gelöst durch einen elektronischen Sicherungsschaltkreis zum Absichern eines mehrkanaligen elektronischen Stromverteilers, wobei der elektronische Sicherungsschaltkreis folgendes umfasst: einen Treiberschaltkreis für jeden Kanal des elektronischen Stromverteilers, wobei der Treiberschaltkreis ausgebildet ist, einen elektronischen Schalter eines entsprechenden Kanals des elektronischen Stromverteilers anzusteuern, einen bestimmten Zustand einzunehmen; eine Mikrocontroller-Schnittstelle, welche ausgebildet ist, eine Anweisung zum Einstellen des Zustands des elektronischen Schalters eines entsprechenden Kanals des elektronischen Stromverteilers von einem Mikrocontroller zu empfangen, wobei der Treiberschaltkreis des entsprechenden Kanals ausgebildet ist, den Zustand des elektronischen Schalters des entsprechenden Kanals des elektronischen Stromverteilers entsprechend der Anweisung von dem Mikrocontroller einzustellen; und einen Sicherheits-Schaltkreis zum Erkennen einer Fehlfunktion in dem Mikrocontroller und/oder dem elektronischen Stromverteiler, wobei der Treiberschaltkreis eines jeden Kanals ausgebildet ist, bei einer erkannten Fehlfunktion in dem Mikrocontroller und/oder dem Stromverteiler den Zustand des elektronischen Schalters des entsprechenden Kanals des elektronischen Stromverteilers entsprechend einem kanalspezifisch vorkonfigurierten Sicherheitszustand einzustellen.

Mit einem solchen elektronischen Sicherungsschaltkreis lässt sich das Bordnetz von Fahrzeugen unter Einhaltung der geforderten Sicherheitsvorschriften effizient absichern. Der elektronische Sicherungsschaltkreis unterstützt beim elektronischen Schalten und Absichern die Klassifikation bzw. Integrität ASIL B. Der elektronische Sicherungsschaltkreis lässt sich effizient als ASIC, hier auch als "Electronic Fuse Asic" (EFASic) bezeichnet, implementieren und kann als Mixed-Signal Front-End eines Mikrocontrollers implementiert werden. Der elektronische Sicherungsschaltkreis kann damit für eine schnelle Ansteuerung eines elektronischen Stromverteilers sorgen, welche den geforderten, oben beschriebenen Sicherheitsanforderungen genügt.

Der Treiberschaltkreis kann hierbei für jeden Kanal separat den Kanal des elektronischen Stromverteilers in den kanalspezifisch vorkonfigurierten Sicheren Zustand überführen, falls der der Sicherheits-Schaltkreis eine Fehlfunktion im entsprechenden Kanal des elektronischen Stromverteilers festgestellt hat.

Alternativ kann der Treiberschaltkreis bei Detektion einer Fehlfunktion in einem Kanal des elektronischen Stromverteilers alle an den elektronischen Sicherungsschaltkreis angeschlossenen Kanäle des elektronischen Stromverteilers in ihre kanalspezifisch vorkonfigurierten Sicherheitszustände überführen.

Bei Erkennung einer Fehlfunktion im Mikrocontroller kann der Treiberschaltkreis alle an den elektronischen Sicherungsschaltkreis angeschlossenen Kanäle des elektronischen Stromverteilers in ihre kanalspezifisch vorkonfigurierten Sicherheitszustände überführen.

Der kanalspezifisch vorkonfigurierte Sicherheitszustand ist ein Zustand, der den entsprechenden Kanal in einen sicheren Zustand bringt, d.h. ein Zustand in dem keine Überströme auftreten. Meist ist dies der Fall, wenn der Schalter des entsprechenden Kanals von der Stromversorgung bzw. dem Bordnetz getrennt ist. Der kanalspezifisch vorkonfigurierte Sicherheitszustand kann für jeden Kanal unterschiedlich sein oder für alle Kanäle des elektronischen Stromverteilers gleich sein, z.B. wenn alle elektronischen Schalter des elektronischen Stromverteilers in den AUS-Zustand überführt werden, in dem die entsprechenden Leitungen von der Stromversorgung getrennt sind.

Gemäß einer beispielhaften Ausführungsform des elektronischen Sicherungsschaltkreises ist der Treiberschaltkreis eines entsprechenden Kanals des elektronischen Stromverteilers ausgebildet, einen MOSFET Transistor des entsprechenden Kanals anzusteuern.

Damit lässt sich der technische Vorteil erzielen, dass der elektronische Stromverteiler sich kosten- und aufwandsgünstig implementieren lässt unter Nutzung von Standardbauteilen wie MOSFET Transistoren, die mit geringen Kanalwiderständen verfügbar sind.

Gemäß einer beispielhaften Ausführungsform des elektronischen Sicherungsschaltkreises ist der Treiberschaltkreis eines ersten Kanals des elektronischen Stromverteilers ausgebildet, einen MOSFET Transistor eines ersten Typs anzusteuern; und der Treiberschaltkreis eines zweiten Kanals des elektronischen Stromverteilers ist ausgebildet, einen MOSFET Transistor eines zweiten Typs anzusteuern.

Damit lässt sich der technische Vorteil erzielen, dass gemäß ASIL B Klassifikation MOSFETs unterschiedlicher Hersteller mit dem EFASic bzw. dem elektronischen Sicherungsschaltkreis verwendet werden können. Damit ist eine größere Flexibilität des Designs möglich, insbesondere bezüglich Kostenaspekten.

Gemäß einer beispielhaften Ausführungsform des elektronischen Sicherungsschaltkreises ist der Treiberschaltkreis eines ersten Kanals des elektronischen Stromverteilers ausgebildet, einen ersten MOSFET Transistor anzusteuern, der für einen ersten Leitungsquerschnitt einer elektrischen Leitung des elektronischen Stromverteilers spezifiziert ist; und der Treiberschaltkreis eines zweiten Kanals des elektronischen Stromverteilers ist ausgebildet, einen zweiten MOSFET Transistor anzusteuern, der für einen zweiten Leitungsquerschnitt einer elektrischen Leitung des elektronischen Stromverteilers spezifiziert ist.

Damit lässt sich der technische Vorteil erzielen, dass der EFASic bzw. elektronische Sicherungsschaltkreis elektronische Stromverteiler ansteuern kann, die Leitungen zu Lasten unterschiedlicher Leistungsanforderungen aufweisen und damit einen unterschiedlichen Leitungsquerschnitt aufweisen. Es können damit nicht nur gleichartige elektrische Lasten sondern unterschiedliche elektrische Lasten an den elektronischen Stromverteiler angeschlossen werden und durch einen EFASic bzw. elektronischen Sicherungsschaltkreis angesteuert werden. Damit können eine Vielzahl von Leitungen mit sehr wenigen EFASics bzw. elektronischen Sicherungsschaltkreisen implementiert werden, was sehr kosteneffizient ist.

Gemäß einer beispielhaften Ausführungsform des elektronischen Sicherungsschaltkreises umfasst der Sicherheits-Schaltkreis einen Watchdog-Schaltkreis, der ausgebildet ist, eine Fehlfunktion des Mikrocontrollers basierend auf einem Empfang von Lebenszeichen-Signalen über die Mikrocontroller-Schnittstelle in vorgegebenen zeitlichen Abständen zu erkennen.

Damit lässt sich der technische Vorteil erzielen, dass der Mikrocontroller sich effizient überwachen lässt und bei einem Fehlzustand des Mikrocontrollers sich das System durch den elektronischen Sicherungsschaltkreis schnell und effizient in einen sicheren Zustand überführen lässt.

Gemäß einer beispielhaften Ausführungsform des elektronischen Sicherungsschaltkreises ist der Treiberschaltkreis des entsprechenden Kanals ausgebildet, eine transiente Unterspannung an einer Spannungsversorgungsklemme des entsprechenden Kanals basierend auf einer Erfassung einer Klemmenspannung an der Spannungsversorgungsklemme zu bestimmen; und der Sicherheits-Schaltkreis ist ausgebildet, den elektronischen Schalter des entsprechenden Kanals abzuschalten, wenn die Klemmenspannung einen ersten Abschaltschwellwert unterschreitet.

Damit lässt sich der technische Vorteil erzielen, dass der elektronische Sicherungsschaltkreis schnell und effizient eine transiente Unterspannung erkennen kann, die beispielsweise bei einem Kurzschluss der Bordnetzspannung eintreten kann, und diese einbrechen lässt. in einen sicheren Zustand überführen lässt. Der elektronische Sicherungsschaltkreis kann das System in diesem Fall schnell und sicher in einen sicheren Betriebszustand überführen entsprechend dem kanalspezifisch vorkonfigurierten Sicherheitszustand.

Gemäß einer beispielhaften Ausführungsform des elektronischen Sicherungsschaltkreises ist der Treiberschaltkreis des entsprechenden Kanals ausgebildet, eine stationäre Unterspannung an der Spannungsversorgungsklemme des entsprechenden Kanals, die sich basierend auf einer zeitlichen Mittelung der erfassten Klemmenspannung bestimmt, von dem Mikrocontroller über die Mikrocontroller-Schnittstelle zu empfangen; und der Treiberschaltkreis des entsprechenden Kanals ist ausgebildet, den MOSFET Transistor abzuschalten, wenn die über die Mikrocontroller-Schnittstelle erhaltene stationäre Unterspannung einen zweiten Abschaltschwellwert überschreitet.

Damit lässt sich der technische Vorteil erzielen, dass eine stationäre Unterspannung, im Gegensatz zur transienten Unterspannung, effizient durch den Mikrocontroller unter Anwendung der entsprechenden Erkennungsalgorithmen detektiert werden kann. In diesem Fall, der erst durch zeitliche Mittelung über ein gewisses Zeitintervall erkannt wird, kann der elektronische Sicherungsschaltkreis das System bei Anweisung durch den Mikrocontroller über die Mikrocontroller-Schnittstelle sicher in den sicheren Betriebszustand überführen.

Gemäß einer beispielhaften Ausführungsform des elektronischen Sicherungsschaltkreises ist der Treiberschaltkreis des entsprechenden Kanals ausgebildet, die erfasste Klemmenspannung an der Spannungsversorgungsklemme zur Bestimmung der stationären Unterspannung über die Mikrocontroller-Schnittstelle an den Mikrocontroller zu übertragen.

Damit lässt sich der technische Vorteil erzielen, dass dem Mikrocontroller die erfasste Klemmenspannung übermittelt wird, so dass er die entsprechenden Erkennungsalgorithmen zur Erkennung einer stationären Unterspannung ausführen kann.

Gemäß einer beispielhaften Ausführungsform des elektronischen Sicherungsschaltkreises umfasst der elektronische Schalter des entsprechenden Kanals einen MOSFET Transistor; der Treiberschaltkreis des entsprechenden Kanals ist ausgebildet, eine transiente Überlast in dem entsprechenden Kanal basierend auf einer Erfassung einer Differenzspannung eines Drain Anschlusses und eines Source Anschlusses des MOSFET Transistors zu bestimmen; und der Sicherheits-Schaltkreis ist ausgebildet, den MOSFET Transistor abzuschalten, wenn die Differenzspannung einen dritten Abschaltschwellwert überschreitet.

Damit lässt sich der technische Vorteil erzielen, dass der elektronische Sicherungsschaltkreis schnell und effizient eine transiente Überlast erkennen kann, die beispielsweise auftreten kann, wenn eine Last mit einer höheren Stromaufnahme als spezifiziert, an den entsprechenden Kanal angeschlossen wird oder wenn eine Fehlfunktion im Stromverteiler vorliegt, z.B. ein Kurzschluss, der zu einem schnell ansteigenden Stromfluss führt. Der elektronische Sicherungsschaltkreis kann das System in diesem Fall schnell und sicher in einen sicheren Betriebszustand überführen entsprechend dem kanalspezifisch vorkonfigurierten Sicherheitszustand.

Gemäß einer beispielhaften Ausführungsform des elektronischen Sicherungsschaltkreises ist der Treiberschaltkreis des entsprechenden Kanals ausgebildet, einen stationären Überstrom des entsprechenden Kanals, der sich basierend auf einem RDSON Modell des MOSFET Transistors bestimmt, von dem Mikrocontroller über die Mikrocontroller-Schnittstelle zu empfangen; und der Treiberschaltkreis des entsprechenden Kanals ist ausgebildet, den MOSFET Transistor abzuschalten, wenn der über die Mikrocontroller-Schnittstelle erhaltene stationäre Überstrom einen vierten Abschaltschwellwert überschreitet.

Damit lässt sich der technische Vorteil erzielen, dass ein stationärer Überstrom, im Gegensatz zu einem transienten Überstrom, effizient durch den Mikrocontroller unter Anwendung des RDSON Modells bzw. Kanalmodell des MOSFET Transistors bestimmt werden kann. In diesem Fall, der erst durch aufwendige Algorithmen im Mikrocontroller erkannt wird, kann der elektronische Sicherungsschaltkreis das System bei Anweisung durch den Mikrocontroller über die Mikrocontroller-Schnittstelle sicher in den sicheren Betriebszustand überführen.

Gemäß einer beispielhaften Ausführungsform des elektronischen Sicherungsschaltkreises ist der Treiberschaltkreis des entsprechenden Kanals ausgebildet, die Differenzspannung des Drain Anschlusses und des Source Anschlusses des MOSFET Transistors zur Bestimmung des RDSON Modells über die Mikrocontroller-Schnittstelle an den Mikrocontroller zu übertragen.

Damit lässt sich der technische Vorteil erzielen, dass dem Mikrocontroller die Differenzspannung U_DS zwischen Drain und Source des MOSFET-Transistors übermittelt wird, so dass er das RDSON Modell bestimmen kann.

Gemäß einer beispielhaften Ausführungsform des elektronischen Sicherungsschaltkreises ist der Treiberschaltkreis des entsprechenden Kanals ausgebildet, eine Gehäusetemperatur des MOSFET Transistors des entsprechenden Kanals zu erfassen und zur Bestimmung des RDSON Modells über die Mikrocontroller-Schnittstelle an den Mikrocontroller zu übertragen.

Damit lässt sich der technische Vorteil erzielen, dass dem Mikrocontroller die Gehäusetemperatur des MOSFET-Transistors übermittelt wird, so dass er das RDSON Modell abhängig von der Temperatur bestimmen kann, was eine sehr genaue Bestimmung des stationären Überstroms ermöglicht.

Gemäß einer beispielhaften Ausführungsform des elektronischen Sicherungsschaltkreises umfasst der elektronische Sicherungsschaltkreis zumindest ein Register zum Speichern der Abschaltschwellwerte; und der elektronische Sicherungsschaltkreis ist ausgebildet, die Abschaltschwellwerte über die Mikrocontroller-Schnittstelle zu empfangen und in dem zumindest einem Register zu speichern.

Damit lässt sich der technische Vorteil erzielen, dass sich die Abschaltschwellwerte adaptiv durch den Mikrocontroller einstellen lassen, um sich ändernde Konfigurationen, z.B. des elektronischen Stromverteilers zu berücksichtigen.

Gemäß einer beispielhaften Ausführungsform des elektronischen Sicherungsschaltkreises umfasst der elektronische Sicherungsschaltkreis einen digitalen Zustandsautomaten zum Speichern der Zustände der elektronischen Schalter der jeweiligen Kanäle des elektronischen Stromverteilers; und der Treiberschaltkreis des entsprechenden Kanals ist ausgebildet, bei einer Einstellung des Zustands des elektronischen Schalters des entsprechenden Kanals den digitalen Zustandsautomaten entsprechend einzustellen.

Damit lässt sich der technische Vorteil erzielen, dass über den digitalen Zustandsautomaten der elektronische Sicherungsschaltkreis über genügend Informationen verfügt, um im Fehlerfall den elektronischen Stromverteiler in einen sicheren Zustand zu überführen.

Gemäß einem zweiten Aspekt wird die oben beschriebene Aufgabe gelöst durch ein Verfahren zum Absichern eines mehrkanaligen elektronischen Stromverteilers, wobei das Verfahren folgendes umfasst: Ansteuern eines elektronischen Schalters eines entsprechenden Kanals des elektronischen Stromverteilers, einen bestimmten Zustand einzunehmen, durch einen Treiberschaltkreis für jeden Kanal des elektronischen Stromverteilers; Empfangen einer Anweisung zum Einstellen des Zustands des elektronischen Schalters eines entsprechenden Kanals des elektronischen Stromverteilers, von einem Mikrocontroller über eine Mikrocontroller-Schnittstelle; Einstellen des Zustands des elektronischen Schalters des entsprechenden Kanals des elektronischen Stromverteilers, durch den Treiberschaltkreis des entsprechenden Kanals, entsprechend der Anweisung des Mikrocontrollers; Erkennen einer Fehlfunktion in dem Mikrocontroller und/oder dem elektronischen Stromverteiler durch einen Sicherheits-Schaltkreis; und Einstellen des Zustands des elektronischen Schalters des entsprechenden Kanals des elektronischen Stromverteilers, durch den Treiberschaltkreis eines jeden Kanals, entsprechend einem kanalspezifisch vorkonfigurierten Sicherheitszustand, wenn eine Fehlfunktion in dem Mikrocontroller und/oder dem Stromverteiler erkannt ist.

Mit einem solchen Verfahren lässt sich das Bordnetz von Fahrzeugen unter Einhaltung der geforderten Sicherheitsvorschriften effizient absichern. Das Verfahren unterstützt beim elektronischen Schalten und Absichern die Klassifikation bzw. Integrität ASIL B. Der elektronische Sicherungsschaltkreis lässt sich effizient als ASIC, hier auch als "Electronic Fuse Asic" (EFASic) bezeichnet, implementieren und kann als Mixed-Signal Front-End eines Mikrocontrollers implementiert werden. Das Verfahren kann damit für eine schnelle Ansteuerung eines elektronischen Stromverteilers sorgen, welche den geforderten, oben beschriebenen Sicherheitsanforderungen genügt. Das Verfahren lässt sich einfach als Computerprogramm realisieren und kann z.B. auf dem elektronischen Sicherungsschaltkreis bzw. EFASic ausgeführt werden.

Gemäß einem dritten Aspekt der Erfindung wird die Aufgabe gelöst durch ein Computerprogramm mit einem Programmcode zum Ausführen des Verfahrens gemäß dem zweiten Aspekt auf einer Steuerung, insbesondere einem elektronischen Sicherungsschaltkreis gemäß dem ersten Aspekt.

Damit wird der technische Vorteil erreicht, dass das Computerprogramm einfach auf einer Steuerung, wie z.B. auf dem elektronischen Sicherungsschaltkreis bzw. EFASic ausgeführt werden kann.

Im Folgenden wird die Erfindung anhand von Ausführungsbeispielen und den Figuren näher beschrieben. In den Figuren zeigen:
- Fig. 1: eine schematische Darstellung eines elektronischen Stromverteilersystems 100 mit einem elektronischen Sicherungsschaltkreis 110 zum Absichern eines mehrkanaligen elektronischen Stromverteilers 120 gemäß der Offenbarung;
- Fig. 2: eine schematische Darstellung eines elektronischen Stromverteilersystems 200 mit einem elektronischen Sicherungsschaltkreis 110 zum Absichern eines mehrkanaligen elektronischen Stromverteilers 120 gemäß einem Ausführungsbeispiel;
- Fig. 3: eine schematische Darstellung der Architektur eines elektronischen Stromverteilersystems 300 mit Darstellung der Software- und Hardware Komponenten auf dem Mikrocontroller und dem EFASic 110 gemäß einem Ausführungsbeispiel; und
- Fig. 4: eine schematische Darstellung eines Verfahrens 400 zum Absichern eines mehrkanaligen elektronischen Stromverteilers gemäß der Offenbarung.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

In dieser Offenbarung werden Kriterien und Anforderungen zur Funktionalen Sicherheit (FUSI) in Fahrzeugen beschrieben. Funktionale Sicherheit bezeichnet den Teil der Sicherheit eines Systems, der von der korrekten Funktion des sicherheitsbezogenen Systems und anderer risikomindernder Maßnahmen abhängt. Die Funktionale Sicherheit wird im Automobil-Bereich üblicherweise in Form von ASIL ("Automotive Safety Integrity Level") Klassen beschrieben. Die ASIL-Klassifikation setzt sich aus verschiedenen Faktoren zusammen, diese sind 1) "Severity - S" entsprechend der Schwere des Fehlers, der Gefährdung des Nutzers oder der Umgebung; 2) "Exposure - E" entsprechend der Eintrittswahrscheinlichkeit, d.h. Häufigkeit und/oder Dauer des Betriebszustands; 3) "Controllability - C" entsprechend der Beherrschbarkeit des Fehlers. Aus diesen Faktoren ergeben sich vier verschiedene ASIL-Level: ASIL A: empfohlene Ausfallwahrscheinlichkeit kleiner 10⁻⁶ / Stunde; ASIL B: empfohlene Ausfallwahrscheinlichkeit kleiner 10⁻⁷ / Stunde; ASIL C: geforderte Ausfallwahrscheinlichkeit kleiner 10⁻⁷ / Stunde; ASIL D: geforderte Ausfallwahrscheinlichkeit kleiner 10⁻⁸ / Stunde.

In dieser Offenbarung werden Stromverteiler beschrieben. Ein Stromverteiler, ist ein Gerät oder eine Anordnung, z.B. auf einer Leiterplatte, in dem Sicherungs- und Schaltelemente zur Verteilung von elektrischer Energie, vornehmlich im Bereich des Niederspannungsnetzes untergebracht sind. Er befindet sich in praktisch jedem elektrifizierten Fahrzeug oder Gebäude. Von Stromverteilern führen elektrische Leitungen entweder direkt zu den Verbrauchsstellen, zum Beispiel zu den Sensoren, dem Lüfter oder der Innenraumbeleuchtung im KFZ oder zum nächsten untergeordneten Stromverteiler.

In dieser Offenbarung werden elektronische Schalter beschrieben. Ein elektronischer Schalter, auch Analogschalter oder Halbleiterschalter genannt, ist Bestandteil einer elektronischen Schaltung, die die Funktion eines elektromechanischen Schalters realisiert. Dabei können als Schaltelemente Feldeffekttransistoren (FET), z.B. Metall-Oxid-Halbleiter FETs, und Bipolartransistoren sowie Dioden zum Einsatz kommen. Im weiteren Sinn können auch Thyristoren und Halbleiterrelais als elektronische Schalter verwendet werden.

In dieser Offenbarung werden Metall-Oxid-Halbleiter Feldeffekttransistoren beschrieben. Ein Metall-Oxid-Halbleiter-Feldeffekttransistor (MOSFET) ist eine zu den Feldeffekttransistoren mit isoliertem Gate gehörende Bauform eines Transistors, der sich durch einen Schichtstapel aus einer metallischen Gate-Elektrode, einem Halbleiter und dem dazwischen befindlichem oxidischen Dielektrikum bestimmt. Dies stellt eine Metall-Isolator-Halbleiter-Struktur dar. Die Steuerung des Stromflusses im Halbleiterbereich zwischen den beiden elektrischen Anschlüssen Drain und Source erfolgt über eine Steuerspannung (Gate-Source-Spannung) bzw. Steuerpotential (Gate-Potential) an einem dritten Anschluss, dem sogenannten Gate.

Dieses ist durch ein Dielektrikum vom Halbleiter (und damit von Drain und Source) elektrisch isoliert.

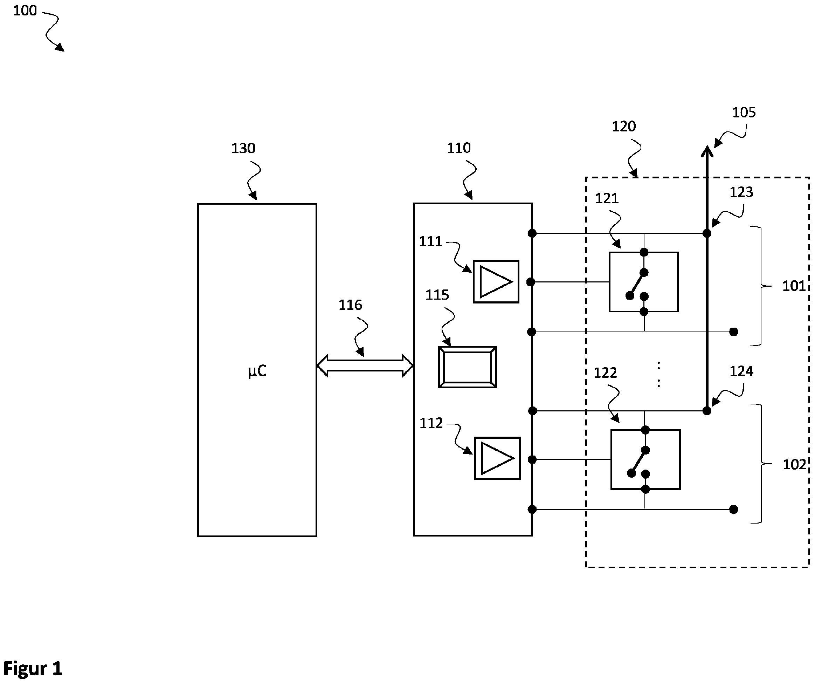

Fig. 1 zeigt eine schematische Darstellung eines elektronischen Stromverteilersystems 100 mit einem elektronischen Sicherungsschaltkreis 110 zum Absichern eines mehrkanaligen elektronischen Stromverteilers 120 gemäß der Offenbarung.

Das elektronischen Stromverteilersystem 100 umfasst einen elektronischen Sicherungsschaltkreis 110, einen mehrkanaligen elektronischen Stromverteiler 120 und einen Mikrocontroller 130.

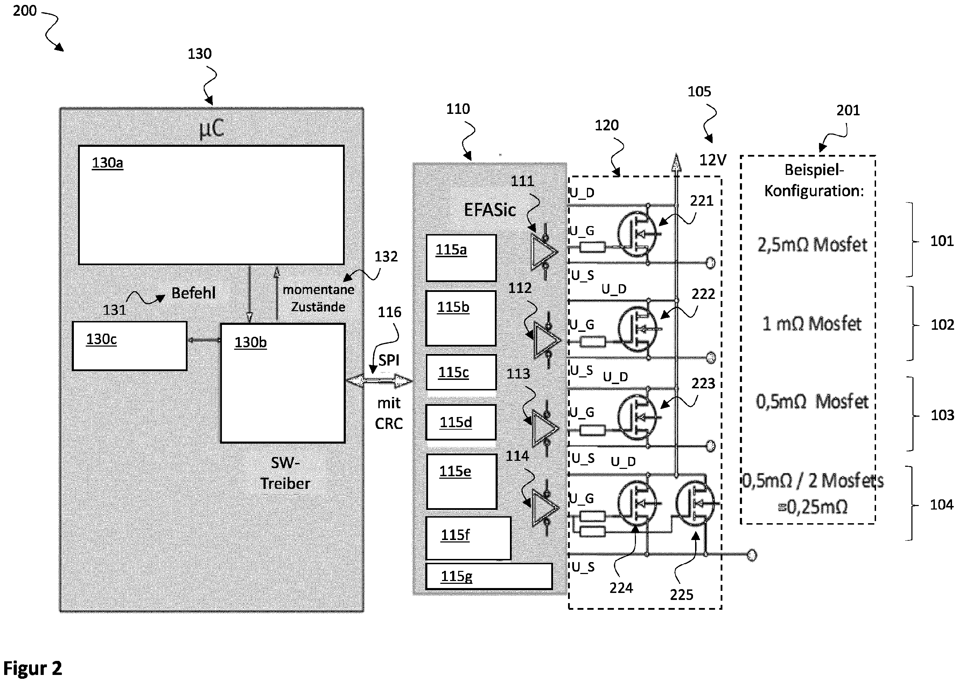

Der mehrkanalige elektronische Stromverteiler 120 umfasst in der Darstellung der Figur 1 eine beispielhafte Anzahl von zwei Kanälen 101, 102. Jeder Kanal 101, 102 umfasst einen elektronischen Schalter 121, 122 zum Ein- oder Ausschalten einer Stromversorgung 105, z.B. des Bordnetzes an einen Lastpfad mit einer Last (nicht dargestellt) wie zum Beispiel einer Innenraumbeleuchtung, einer Kühlung, einer Fensterhebeanlage, etc. Jeder Kanal 101, 102 umfasst eine Spannungsversorgungsklemme 123, 124, welche an die Strom- bzw. Spannungsversorgung 105 anschließbar ist, um die Last mit Strom zu versorgen. In Figur 1 sind eine beispielhafte Anzahl von zwei Kanälen 101, 102 dargestellt. Andere Konfigurationen mit unterschiedlicher Anzahl von Kanälen sind natürlich auch realisierbar, z.B. eine Konfiguration mit vier Kanälen, wie beispielsweise in Figur 2 dargestellt oder eine Konfiguration mit 3, 5, 6, 7, 8 oder mehr Kanälen. Es versteht sich, dass auch eine Konfiguration von nur einem Kanal realisierbar ist, und in dieser Offenbarung mit eingeschlossen ist.

Der elektronische Sicherungsschaltkreis 110 dient zum Absichern des mehrkanaligen elektronischen Stromverteilers 120. Der elektronische Sicherungsschaltkreis 110 umfasst einen Treiberschaltkreis 111, 112 für jeden Kanal 101, 102 des elektronischen Stromverteilers 120. Der Treiberschaltkreis 111, 112 ist ausgebildet, einen elektronischen Schalter 121, 122 eines entsprechenden Kanals 101, 102 des elektronischen Stromverteilers 120 anzusteuern, einen bestimmten Zustand einzunehmen.

Der elektronische Sicherungsschaltkreis 110 umfasst eine Mikrocontroller-Schnittstelle 116, welche ausgebildet ist, eine Anweisung zum Einstellen des Zustands des elektronischen Schalters 121, 122 eines entsprechenden Kanals 101, 102 des elektronischen Stromverteilers 120 von dem Mikrocontroller 130 zu empfangen.

Der Treiberschaltkreis 111, 112 des entsprechenden Kanals 101, 102 ist ausgebildet, den Zustand des elektronischen Schalters 121, 122 des entsprechenden Kanals des elektronischen Stromverteilers 120 entsprechend der Anweisung von dem Mikrocontroller 130 einzustellen.

Der elektronische Sicherungsschaltkreis 110 umfasst ferner einen Sicherheits-Schaltkreis 115 zum Erkennen einer Fehlfunktion in dem Mikrocontroller 130 und/oder dem elektronischen Stromverteiler 120.

Der Treiberschaltkreis 111, 112 eines jeden Kanals 101, 102 ist ausgebildet, bei einer erkannten Fehlfunktion in dem Mikrocontroller 130 und/oder dem Stromverteiler 120 den Zustand des elektronischen Schalters 121, 122 des entsprechenden Kanals 101, 102 des elektronischen Stromverteilers 120 entsprechend einem kanalspezifisch vorkonfigurierten Sicherheitszustand einzustellen.

Dieser Sicherheitszustand ist im Allgemeinen ein Zustand, in dem der elektronische Schalter des entsprechenden Kanals ausgeschaltet ist und damit von der Stromversorgung 105 getrennt ist. Unter Umständen kann der vorkonfigurierte Sicherheitszustand aber auch ein eingeschalteter Zustand des elektronischen Schalters 121, 122 sein, z.B. für den Fall einer Notstrombeleuchtung oder einer Absetzung eines Notrufsignals.

Der Treiberschaltkreis 111, 112, 113, 114 eines entsprechenden Kanals 101, 102, 103, 104 des elektronischen Stromverteilers 120 kann beispielsweise ausgebildet sein, einen MOSFET Transistor 221, 222, 223, 224, 225 des entsprechenden Kanals 111, 112, 113, 114 anzusteuern, wie zum Beispiel in Figur 2 näher dargestellt. Der elektronische Schalter 121, 122 kann in diesem Fall als MOSFET Transistor 221, 222 realisiert sein.

In einer Ausführungsform kann der Treiberschaltkreis 111 des ersten Kanals 101 des elektronischen Stromverteilers 120 ausgebildet sein, einen MOSFET Transistor 221 eines ersten Typs anzusteuern; und der Treiberschaltkreis 112 des zweiten Kanals 102 des elektronischen Stromverteilers 120 kann ausgebildet sein, einen MOSFET Transistor 222 eines zweiten Typs anzusteuern.

In einer Ausführungsform kann der Treiberschaltkreis 111 des ersten Kanals 101 des elektronischen Stromverteilers 120 ausgebildet sein, einen ersten MOSFET Transistor 221 anzusteuern, der für einen ersten Leitungsquerschnitt einer elektrischen Leitung des elektronischen Stromverteilers 120 spezifiziert ist; und der Treiberschaltkreis 112 des zweiten Kanals 102 des elektronischen Stromverteilers 120 kann ausgebildet sein, einen zweiten MOSFET Transistor 222 anzusteuern, der für einen zweiten Leitungsquerschnitt einer elektrischen Leitung des elektronischen Stromverteilers 120 spezifiziert ist.

Der Sicherheits-Schaltkreis 115 kann einen Watchdog-Schaltkreis 115f umfassen, wie beispielsweise zu Figur 2 näher dargestellt, der ausgebildet ist, eine Fehlfunktion des Mikrocontrollers 130 basierend auf einem Empfang von Lebenszeichen-Signalen über die Mikrocontroller-Schnittstelle 116 in vorgegebenen zeitlichen Abständen zu erkennen.

Der Treiberschaltkreis 111, 112 des entsprechenden Kanals 101, 102 kann ausgebildet sein, eine transiente Unterspannung an einer Spannungsversorgungsklemme 123, 124 des entsprechenden Kanals 101, 102 basierend auf einer Erfassung einer Klemmenspannung an der Spannungsversorgungsklemme 123, 124 zu bestimmen. Der Sicherheits-Schaltkreis 115 kann ausgebildet sein, den elektronischen Schalter 121, 122 des entsprechenden Kanals 101, 102 abzuschalten, wenn die Klemmenspannung einen ersten Abschaltschwellwert unterschreitet.

Der Treiberschaltkreis 111, 112 des entsprechenden Kanals 101, 102 kann ausgebildet sein, eine stationäre Unterspannung an der Spannungsversorgungsklemme 123, 124 des entsprechenden Kanals 101, 102, die sich basierend auf einer zeitlichen Mittelung der erfassten Klemmenspannung bestimmt, von dem Mikrocontroller 130 über die Mikrocontroller-Schnittstelle 116 zu empfangen. Der Treiberschaltkreis 111, 112 des entsprechenden Kanals 101, 102 kann ausgebildet sein, den MOSFET Transistor 221, 222 abzuschalten, wenn die über die Mikrocontroller-Schnittstelle 116 erhaltene stationäre Unterspannung einen zweiten Abschaltschwellwert überschreitet.

Der Treiberschaltkreis 111, 112 des entsprechenden Kanals 101, 102 kann ausgebildet sein, die erfasste Klemmenspannung an der Spannungsversorgungsklemme 123, 124 zur Bestimmung der stationären Unterspannung über die Mikrocontroller-Schnittstelle 116 an den Mikrocontroller 130 zu übertragen.

Der elektronische Schalter 121, 122 des entsprechenden Kanals 101, 102 kann einen MOSFET Transistor 221, 222 umfassen, wie beispielsweise in Figur 2 näher beschrieben. Der Treiberschaltkreis 111, 112 des entsprechenden Kanals 101, 102 kann ausgebildet sein, eine transiente Überlast in dem entsprechenden Kanal basierend auf einer Erfassung einer Differenzspannung U_D-U_S eines Drain Anschlusses und eines Source Anschlusses des MOSFET Transistors 221, 222 zu bestimmen. Der Sicherheits-Schaltkreis 115 kann ausgebildet sein, den MOSFET Transistor 221, 222 abzuschalten, z.B. über Ansteuerung des entsprechenden Treiberschaltkreises 111, 112, wenn die Differenzspannung einen dritten Abschaltschwellwert überschreitet.

Der Treiberschaltkreis 111, 112 des entsprechenden Kanals 101, 102 kann ausgebildet sein, einen stationären Überstrom des entsprechenden Kanals, der sich basierend auf einem RDSON Modell des MOSFET Transistors 221, 222 bestimmt, von dem Mikrocontroller 130 über die Mikrocontroller-Schnittstelle 116 zu empfangen. Der Treiberschaltkreis 111, 112 des entsprechenden Kanals 101, 102 kann ausgebildet sein, den MOSFET Transistor 221, 222 abzuschalten, wenn der über die Mikrocontroller-Schnittstelle 116 erhaltene stationäre Überstrom einen vierten Abschaltschwellwert überschreitet.

RDSON bzw. R_{DS(on)} ist eine Bezeichnung für den Einschaltwiderstand oder auch einen minimalen Durchgangswiderstand eines Feldeffekttransistors, wobei das R für den elektrischen Widerstand steht. Der Index DS steht für die Anschlussleitungen des Feldeffekttransistors, die als Drain (D) und Source (S) bezeichnet werden. Das ON (englisch für "an") steht für den eingeschalteten Zustand des Feldeffekttransistors im Schaltbetrieb.

Im voll durchgeschalteten Zustand ist der Feldeffekttransistor niederohmig, es können Werte unterhalb von 1 m• erreicht werden. Aus dem R_{DS(on)} kann auf die minimal erreichbaren Schaltverluste des Transistors geschlossen werden. Der R_{DS(on)} wird meist in Datenblättern und Katalogen als Kenngröße explizit mit angegeben.

Über den R_{DS(on)} kann aus einer Spannungsmessung zwischen den Drain- und Source-Anschlüssen der Kanalstrom des MOSFET bestimmt werden.

Der Treiberschaltkreis 111, 112 des entsprechenden Kanals 101, 102 kann ausgebildet sein, die Differenzspannung U_D - U_S des Drain Anschlusses und des Source Anschlusses des MOSFET Transistors 221, 222 zur Bestimmung des RDSON Modells über die Mikrocontroller-Schnittstelle 116 an den Mikrocontroller 130 zu übertragen.

Der Treiberschaltkreis 111, 112 des entsprechenden Kanals 101, 102 kann ausgebildet sein, eine Gehäusetemperatur des MOSFET Transistors 221, 222 des entsprechenden Kanals 101, 102 zu erfassen und zur Bestimmung des RDSON Modells über die Mikrocontroller-Schnittstelle 116 an den Mikrocontroller 130 zu übertragen. Beispielsweise kann die Gehäusetemperatur über einen NTC-Widerstand bestimmt werden, der nahe des Gehäuses angebracht ist.

Der NTC-Widerstand bzw. Heißleiter oder NTC-Thermistor ("*Negative Temperature Coefficient Thermistor*") ist ein temperaturabhängiger Widerstand, der als wesentliche Eigenschaft einen negativen Temperaturkoeffizienten aufweist und bei hohen Temperaturen den elektrischen Strom besser leitet als bei tiefen Temperaturen. Der NTC-Widerstand bzw. Widerstandsthermometer nutzt die Temperaturabhängigkeit des elektrischen Widerstandes eines elektrischen Leiters zur Messung der Temperatur aus.

Der elektronische Sicherungsschaltkreis 110 kann zumindest ein Register 115c zum Speichern der Abschaltschwellwerte, d.h. der oben erwähnten ersten, zweiten, dritten und vierten Abschaltschwellwerte aufweisen. Der elektronische Sicherungsschaltkreis 110 kann ausgebildet sein, die Abschaltschwellwerte über die Mikrocontroller-Schnittstelle 116 zu empfangen und in dem zumindest einem Register 115c zu speichern.

Der elektronische Sicherungsschaltkreis 110 kann ferner einen digitalen Zustandsautomaten bzw. "State Machine" 115b zum Speichern der Zustände der elektronischen Schalter 121, 122 der jeweiligen Kanäle 101, 102 des elektronischen Stromverteilers 120 aufweisen. Der Treiberschaltkreis 111, 112 des entsprechenden Kanals 101, 102 kann ausgebildet sein, bei einer Einstellung des Zustands des elektronischen Schalters 121, 122 des entsprechenden Kanals 101, 102 den digitalen Zustandsautomaten 115b entsprechend einzustellen.

Es versteht sich, dass der digitale Zustandsautomat neben den Zuständen der elektronischen Schalter 121, 122 auch andere Zustände der entsprechenden Kanäle 101, 102 speichern kann.

Fig. 2 zeigt eine schematische Darstellung eines elektronischen Stromverteilersystems 200 mit einem elektronischen Sicherungsschaltkreis 110 zum Absichern eines mehrkanaligen elektronischen Stromverteilers 120 gemäß einem Ausführungsbeispiel.

Das elektronische Stromverteilersystem 200 ist eine spezielle Konfiguration des oben zu Figur 1 beschriebenen elektronischen Stromverteilersystem 100, bei dem die elektronischen Schalter 121, 122 als MOSFET Transistoren 221, 222, 223, 224 ausgebildet sind, und bei dem der elektronische Stromverteiler 120 eine Anzahl von vier Kanälen aufweist. Ferner sind die MOSFET Transistoren 221, 222, 223, 224 entsprechend unterschiedlichen Leitungsquerschnitten spezifiziert. In dieser Beispielkonfiguration 201 ist der MOSFET 221 des ersten Kanals 101 ein 2,5m• MOSFET; der MOSFET 222 des zweiten Kanals 102 ein 1m• MOSFET; der MOSFET 223 des dritten Kanals 103 ein 0,5m• MOSFET; und im vierten Kanal 104 sind zwei parallelgeschaltete MOSFETS 224, 225 angebracht, bei denen es sich jeweils um 0,5m• MOSFETs handelt, was einem effektiven 0,25m• MOSFET entspricht.

Die Source, Drain, und Gate-Anschlüsse der jeweiligen MOSFET Transistoren sind an die Treiberschaltkreise 111, 112, 113, 114 der entsprechenden Kanäle 101, 102, 103, 104 des elektronischen Sicherungsschaltkreises 110 angeschlossen, so dass die jeweiligen Source- und Drain-Spannungen U_S und U_D von den Treiberschaltkreisen erfasst werden können und die jeweilige Gate-Spannung durch die entsprechenden Treiberschaltkreise an die MOSFET-Transistoren angelegt werden können, um diese anzusteuern bzw. ein- oder auszuschalten.

In dem elektronischen Sicherungsschaltkreis 110, der hier als EFASic ausgeführt ist, sind die folgenden Funktionalitäten implementiert: ein Gatetreiber mit Ladungspumpe bzw. DC/DC-Wandler 115a zur Gate-Ansteuerung der entsprechenden MOSFETs; ein Zustandsautomat bzw. State Machine 115b zur Speicherung der jeweiligen Zustände der Kanäle; ein oder mehrere Register 115c für die Konfiguration und SPI Kommunikation, z.B. für die Ablage von Konfigurationsdaten oder sonstiger Parameter, die beispielsweise über die Mikrocontroller Schnittstelle 116 empfangen oder gesendet werden; ein Analog-Digital-Wandler (ADC) 115d zur Umwandlung zwischen digitalen und analogen Signalen; ein Schaltkreis zum schnellen Abschalten der elektronischen Schalter 115e; ein Windows Watchdog 115f und ein Diagnose-Schaltkreis 115g.

Die Bordnetzspannung 105 ist beispielsweise 12V.

Die Mikrocontroller-Schnittstelle 116 ist eine Kommunikations-Schnittstelle zur Kommunikation mit dem Mikrocontroller 130, die hier als SPI implementiert sein kann. Das Serial Peripheral Interface (SPI) ist ein Bus-System, das einen Standard für einen synchronen seriellen Datenbus darstellt, mit dem digitale Schaltungen nach dem Master-Slave-Prinzip miteinander verbunden werden können.

Der Mikrocontroller 130 umfasst eine oder mehrere Software-Komponenten 130a, die über Befehle 131 mit dem Software-Treiber 130b kommuniziert. Der Software-Treiber umfasst eine API (applikationsspezifische Interface) Konfiguration, eine Software-definierte Charakteristik, und ein Diagnose-Tool.

Der Software-Treiber 130b teilt die momentanen Zustände 132 der Software-Komponente 130a mit. Der Mikrocontroller 130 umfasst ferner eine Watchdog Antwort Komponente 130c, die Antworten des Software-Treibers 130b überwacht, um die Funktionsfähigkeit des Software-Treibers 130b zu überwachen.

Figur 2 zeigt somit das EFASic 110 als Mixed Signal Front-End zu einem µC 130. Das EFASic 110 hat typischerweise 4 Kanäle 101, 102, 103, 104, kann aber auch 1 bis 8 Kanäle aufweisen. Das EFASic 110 weist analoge Anteile auf, wie z.B. Gatetreiber und Ladungspumpen (oder DC/DC Wandler) 115a. Daneben weist es eine Digitale State Machine 115b auf mit Registern 115c für die Konfiguration und SPI Kommunikation.

In dem Ausführungsbeispiel der Figur 2 ist die sehr effiziente Funktionsaufteilung zwischen µC 130 mit DSP-Kernel oder ALU und Mixed Signal Frontend EFASic 110 dargestellt.

Das Grundkonzept ist wie folgt:
Alle schnellen Vorgänge laufen auf dem EFASic 110, meist Hard-Wired, d.h. festverdrahtet ausgeführt. Das EFASic 110 kann bei Fehler des µCs 130 oder der Peripherie eigenständig den vorkonfigurierten Save State eines Kanals einstellen, d.h. AN oder AUS. Das EFASic 110 weist einen Windows-Watchdog 115f auf, um Fehler des µCs 130 zu erkennen. Das EFASic 110 hat alle Mechanismen für eine ASIL Integrität des Schaltens mit Sicherheitsziel "Provide Supply", "Save State ON". Das EFASic 110 hat alle Mechanismen für eine ASIL B Integrität des Schaltens mit Sicherheitsziel "Disconnect Overload", "Save State OFF". Das EFASic 110 weist eine Schnellabschaltung bei transienter Überlast gemäß ASIL B auf. Basis hierfür ist die Messung der Differenzspannung UDS zwischen Drain und Source. Das EFASic 110 weist eine Schnellabschaltung bei transienter Unterspannung gemäß ASIL B auf. Basis hierfür ist die Messung der Klemme 30 Spannung bzw. der Klemme, an der die Netzspannung 105 anliegt. Das EFASic 110 stellt eine Temperaturmessung für jeden Kanal bereit. Basis hierfür ist die Spannung NTC neben dem MOSFET. Das EFASic 110 stellt eine "Inrush" bzw. Aufstart-Schaltung für Schalten in kapazitive Lasten bereit. Das EFASic 110 weist einen ADC für die Analog-Digital-Umsetzung auf.

Alle mit Algorithmen behafteten Prozesse laufen auf dem µC 130 mit DSP Kernel oder ALU (Arithmetic Logic Unit) und sind in einem Complex-Device Driver 130b zusammengefasst. Hierzu gehören die folgenden Softwarekomponenten bzw. Algorithmen: Berechnung des Rdson der MOSFETs gemäß eines thermischen Modells des Halbleiters. Berechnung des Stromes unter Nutzung des temperaturkompensierten Rdson. Hierzu ist kein externer Shunt notwendig. Berechnung der Temperatur der Leitung gemäß eines thermischen Modells der Leitung oder alternativ Berechnung der Lastcharakteristik und Vergleich mit einer Sicherungscharakteristik über digitale Filter. Kommandierung der Abschaltung bei stationärem Überstrom. Spannungsmesswert-Aufbereitung über Median-Filter. Kommandierung der Abschaltung bei stationärer Unterspannung. Schreiben von Konfigurationsparametern in die Register 115c des EFASic 110, z.B. der Abschaltschwellen der Überlasterkennung.

Für die ASIL B-Integrität sind die folgenden Diagnosemechanismen im EFASic 110 implementiert: Die gesamte Kette der Schnellabschaltung, von der U_{DS} Messung, über den Komparator über die Logikverknüpfung kann im Diagnosemodus über Aufschalten eines Referenzsignales diagnostiziert werden. Die Messung der U_{DS} und Temperaturen wird diagnostiziert. Die Funktion der State-Machine 115b wird diagnostiziert. Das EFASic 110 weist eine Gate-Leckstrom Messung auf, die es erlaubt die Schaltfähigkeit des MOSFETs zu analysieren.

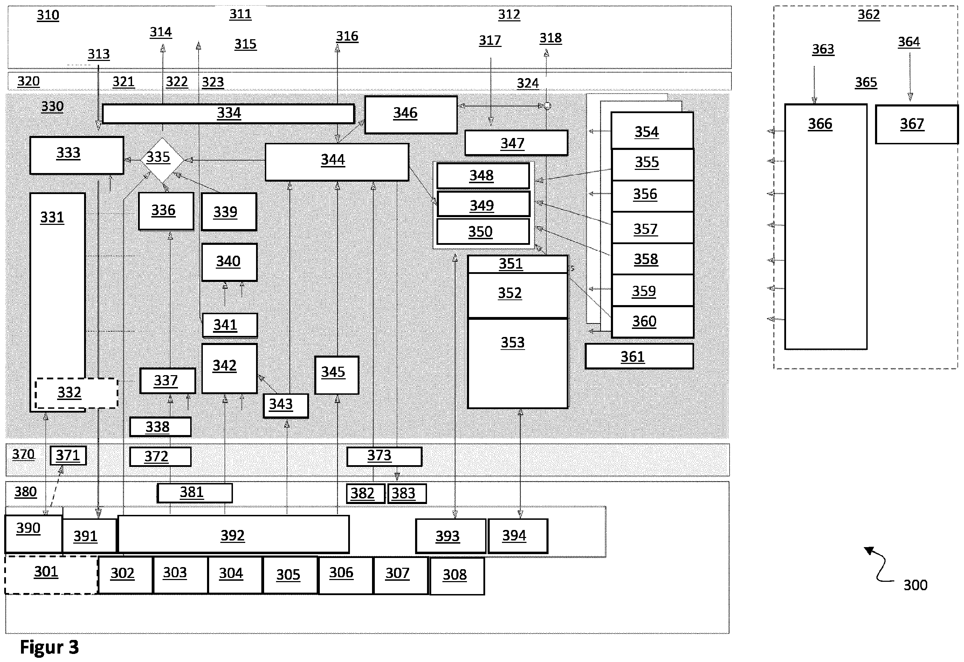

Fig. 3 zeigt eine schematische Darstellung der Architektur eines elektronischen Stromverteilersystems 300 mit Darstellung der Software- und Hardware Komponenten auf dem Mikrocontroller und dem EFASic 110 gemäß einem Ausführungsbeispiel.

Die Architektur der Software- und Hardware Komponenten ist in diesem Beispiel entsprechend dem AUTOSAR (AUTomotive Open System ARchitecture) Standard implementiert. Damit stellt die Architektur eine offene und standardisierte Softwarearchitektur für elektronische Steuergeräte (ECUs) bereit, die skalierbar ist und auf unterschiedlichen Fahrzeug- und Plattformvarianten unter Berücksichtigung von Verfügbarkeits- und Sicherheitsanforderungen implementiert werden kann.

Die Softwarekomponenten, die auf dem EFASic 110 entsprechend Figur 1 oder Figur 2 implementiert werden können, sind in der EFASic-Schicht 380 dargestellt und entsprechend der oben zu Figur 2 dargestellten Funktionalität des EFASic 110 ausgeführt. In der EFASic-Schicht 380 ist die Kommunikation mit dem µC 130 über SPI mit CRC (Cyclic Redundancy Check) 381 implementiert. Ferner sind Interrupt 382 und Enable (ENA) 383 Mechanismen zur Kommunikation mit dem Software-Treiber 130b des Mikrocontrollers 130 implementiert. In der EFASic-Schicht 380 sind ferner folgende Funktionalitäten implementiert, wie bereits oben zu Figur 2 genauer beschrieben: Watchdog-Register 390, Kanal Status Register 391, Kanal Messregister 392, Kanal-Konfigurationsregister 393, Diagnosemode-Register 394, Sicherer Zustand ON Sperren und Lösen 301, Schnelle U_DS Abschaltung 302, ADC 303, State Machine 304, Booster 305, Interne Versorgung 306, Treiber Zustände 307, Diagnose-Referenzen 308.

Die Softwarekomponenten, die auf dem Mikrocontroller 130 entsprechend Figur 1 oder Figur 2 implementiert werden können, also auf dem Software-Treiber 130b des µC 130, wie zu Figur 2 näher beschrieben, sind im Complex-Device Driver für das EFASic 330, d.h. dem Softwaretreiber 330 des EFASic zum Betreiben des EFASic 110 dargestellt und entsprechend der oben zu Figur 2 dargestellten Funktionalität des EFASic 110 ausgeführt.

Der Softwaretreiber 330 des EFASic umfasst einen Windows Watchdog 331, der über die Softwarekomponente "Safe-State ON Lock" mit dem EFASic 110, d.h. dem Watchdog Register 390 kommuniziert, um den sicheren Zustand einzuschalten. Die Kommunikation wird über die MCAL-Schicht 370 geführt, in der ein SPI 372 und ein GPIO 373 gemäß dem AUTOSAR Standard implementiert sind. Die MCAL-Schicht 370 weist ferner ein Reset 371-Modul auf, welches durch das Watchdog-Register 390 angesteuert wird.

Der Complex-Device Driver für das EFASic 330 weist ferner die folgenden Software-Komponenten auf, wie oben zu Figur 2 bereits näher beschrieben: "Soft Terminal to Channel State Mapping" 333, "Time Slice OS trigger (20ms)" 334, Kombinierer 335, "UV Shut-Off" 336, Median-Filter 337, CRC 338, OL Shut-Off 339, "Wire Characteristic" 340, "Ups->I" 341, Temperaturkompensation, Rdson Modell 342, "UT->T" 343, Diagnose-Zyklus 344, "t->I_Gate_Leakage" 345, Fehlerspeicher und Zähler 346, Lese/Reset Kanalstatus 347, Schreibe Konfigurations-Set A 348, Lese Konfigurations-Set und Vergleiche mit B 349, Wiederhole B/C wenn nicht plausibel 350, Initialisierung der Diagnostik 351, Prüfe externe Geräte, Gate Leckmessung, Gate Pull-Down Diagnose, LC Check 352, Prüfe EFASic Funktion mit Referenzquelle: ADC U_DS, T Check, schneller SC shut-off check State Machine Check, Funktionsregister Check, DC-Booster Check 353, Leitungsdurchmesser-Charakteristik Lookup 354, Sicherheitskonfiguration 355, Terminal-Konfiguration 356, Inrush-Konfiguration 357, PWM Konfiguration 358, Unterspannungs-Konfiguration 359, Schnelle Shut-Down Konfiguration 360, A,B,C Konfigurations-Sets mit Plausibilitäts-Check und Reparatur 361.

Die Konfiguration des Complex-Device Driver für das EFASic 330 erfolgt über eine Konfigurations-Schnittstelle "End-Off Line and/or OTA" 362, mit der ein "Single Update" 365 angestoßen werden kann. Über die Konfigurations-Schnittstelle 362 können Metadaten, d.h. "Write Channel Configuration Metadata" 363 von extern eingegeben werden, um die folgenden Konfigurationen an den Complex-Device Driver für das EFASic 330 zu übermitteln: Leitungsdurchmesser, sicherer Zustand On/Off, Terminal-Zuordnung, Inrush-Steuerung (Vorladung), PWM Zyklus, Unterspannung (Schwelle, Zeit), Kanal-MOSFET R_DSon 80°, 0°, -40°. Über eine Kalibration-Eingabe 364 erfolgt eine Kanalmesskalibration 367.

In der Anwendungsschicht 310 sind gemäß AUTOSAR Standard die folgenden Funktionalitäten implementiert: Betrieb/Operation 311, Initialisierungsphase 312, Schreibe Soft Terminal Zustände 313, Empfange Kanalstatus 314, Empfange Kanalmessungen 315, Empfange Kanaldiagnose Ergebnisse 316, Initialisiere 317, Empfange System Bereit Signal 318.

Über das RTI-Interface 320 gemäß AUTOSAR Standard können die Schreib- und Lesebefehle zyklisch 321, 322, 323 oder ereignisgesteuert 324 an den Complex-Device Driver für das EFASic 330 übertragen werden.

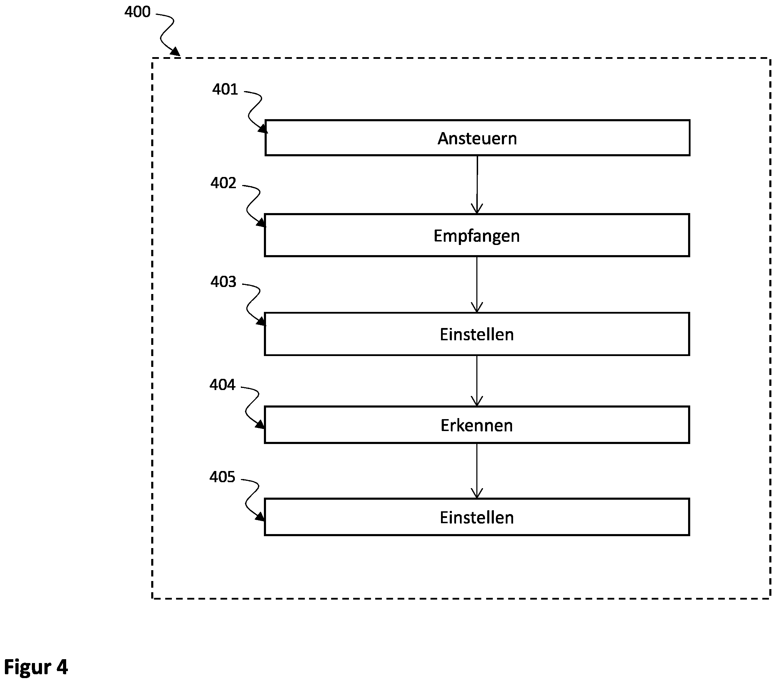

Fig. 4 zeigt eine schematische Darstellung eines Verfahrens 400 zum Absichern eines mehrkanaligen elektronischen Stromverteilers gemäß der Offenbarung.

Das Verfahren 400 dient zum Absichern eines mehrkanaligen elektronischen Stromverteilers 100, 200, 300, wie z.B. oben zu den Figuren 1 bis 3 beschrieben.

Das Verfahren 400 umfasst ein Ansteuern 401 eines elektronischen Schalters 121, 122 eines entsprechenden Kanals des elektronischen Stromverteilers, einen bestimmten Zustand einzunehmen, durch einen Treiberschaltkreis 111, 112 für jeden Kanal des elektronischen Stromverteilers, wie z.B. oben zu den Figuren 1 bis 3 beschrieben.

Das Verfahren 400 umfasst ein Empfangen 402 einer Anweisung zum Einstellen des Zustands des elektronischen Schalters eines entsprechenden Kanals des elektronischen Stromverteilers, von einem Mikrocontroller 130 über eine Mikrocontroller-Schnittstelle 116, wie z.B. oben zu den Figuren 1 bis 3 beschrieben.

Das Verfahren 400 umfasst ein Einstellen 403 des Zustands des elektronischen Schalters des entsprechenden Kanals des elektronischen Stromverteilers, durch den Treiberschaltkreis 111, 112 des entsprechenden Kanals, entsprechend der Anweisung des Mikrocontrollers, wie z.B. oben zu den Figuren 1 bis 3 beschrieben.

Das Verfahren 400 umfasst ein Erkennen 404 einer Fehlfunktion in dem Mikrocontroller 130 und/oder dem elektronischen Stromverteiler 120 durch einen Sicherheits-Schaltkreis 115, wie z.B. oben zu den Figuren 1 bis 3 beschrieben.

Das Verfahren 400 umfasst ein Einstellen 405 des Zustands des elektronischen Schalters des entsprechenden Kanals des elektronischen Stromverteilers, durch den Treiberschaltkreis eines jeden Kanals, entsprechend einem kanalspezifisch vorkonfigurierten Sicherheitszustand, wenn eine Fehlfunktion in dem Mikrocontroller und/oder dem Stromverteiler erkannt ist, wie z.B. oben zu den Figuren 1 bis 3 beschrieben.

Ferner kann ein Computerprogramm mit einem Programmcode zum Ausführen des Verfahrens 400 in einer Steuerung, z.B. auf einem elektronischen Sicherungsschaltkreis 110 wie oben zu den Figuren 1 bis 3 beschrieben, bereitgestellt werden.

### Bezugszeichenliste

- 100: elektronisches Stromverteilersystem
- 101: erster Kanal des Stromverteilers
- 102: zweiter Kanal des Stromverteilers
- 105: Stromversorgung bzw. Bordnetz
- 110: elektronischer Sicherungsschaltkreis bzw. EFASic
- 111: Treiberschaltkreis für den ersten Kanal des Stromverteilers
- 112: Treiberschaltkreis für den zweiten Kanal des Stromverteilers
- 115: Sicherheits-Schaltkreis
- 116: Mikrocontroller-Schnittstelle
- 120: elektronischer Stromverteiler
- 121: elektronischer Schalter des ersten Kanals des Stromverteilers
- 122: elektronischer Schalter des zweiten Kanals des Stromverteilers
- 123: Spannungsversorgungsklemme des ersten Kanals des Stromverteilers
- 124: Spannungsversorgungsklemme des zweiten Kanals des Stromverteilers
- 130: Mikrocontroller

- 200: elektronisches Stromverteilersystem
- 221: MOSFET des ersten Kanals des Stromverteilers
- 222: MOSFET des zweiten Kanals des Stromverteilers
- 223: MOSFET des dritten Kanals des Stromverteilers
- 224: erster MOSFET des vierten Kanals des Stromverteilers
- 225: zweiter MOSFET des vierten Kanals des Stromverteilers
- U_D: Spannung am Drain-Anschluss des MOSFET
- U_S: Spannung am Source-Anschluss des MOSFET
- U_G: Spannung am Gate-Anschluss des MOSFET
- 115a: Gate-Treiber mit Ladungspumpe bzw. DC/DC-Wandler
- 115b: Zustandsautomat bzw. State Machine
- 115c: Register
- 115d: ADC bzw. Analog-Digital-Wandler
- 115e: schnelles Abschalten des elektronischen Schalters
- 115f: Windows Watchdog
- 115g: Diagnose
- 130a: Funktion einer Software-Komponente
- 130b: Software-Treiber mit: API (applikationsspezifischer Interface) Konfiguration, Software-definierte Charakteristik, Diagnose
- 130c: Watchdog Antwort Komponente
- 131: Befehl
- 132: momentane Zustände

- 310: Anwendungsschicht ("Application Layer")
- 311: Betrieb bzw. Operation
- 312: Initialisierungsphase
- 313-318: Ereignisse der Anwendungsschicht
- 320: RTI bzw. Echtzeitinterface
- 321-324: Ereignisse über das RTI
- 330: komplexer Gerätetreiber des EFASic
- 331-361: Komponenten des Gerätetreibers 330
- 362-367: Konfigurationskomponenten für den Gerätetreiber 330
- 370: MCAL bzw. "Mikrocontroller Abstraction Layer" gemäß Autosar Spezifikation
- 371-373: Komponenten des MCAL 370
- 380: EFASic
- 381-394: Komponenten des EFASic
- 301-308: Komponenten des EFASic

- 400: Verfahren zum Absichern eines mehrkanaligen elektronischen Stromverteilers
- 401: 1. Verfahrensschritt
- 402: 2. Verfahrensschritt
- 403: 3. Verfahrensschritt
- 404: 4. Verfahrensschritt
- 405: 5. Verfahrensschritt

## Patentansprüche

1. Elektronischer Sicherungsschaltkreis (110) zum Absichern eines mehrkanaligen elektronischen Stromverteilers (120), wobei der elektronische Sicherungsschaltkreis (110) folgendes umfasst:
einen Treiberschaltkreis (111, 112) für jeden Kanal (101, 102) des elektronischen Stromverteilers (120), wobei der Treiberschaltkreis (111, 112) ausgebildet ist, einen elektronischen Schalter (121, 122) eines entsprechenden Kanals (101, 102) des elektronischen Stromverteilers (120) anzusteuern, einen bestimmten Zustand einzunehmen;
eine Mikrocontroller-Schnittstelle (116), welche ausgebildet ist, eine Anweisung zum Einstellen des Zustands des elektronischen Schalters (121, 122) eines entsprechenden Kanals (101, 102) des elektronischen Stromverteilers (120) von einem Mikrocontroller (130) zu empfangen,
wobei der Treiberschaltkreis (111, 112) des entsprechenden Kanals (101, 102) ausgebildet ist, den Zustand des elektronischen Schalters (121, 122) des entsprechenden Kanals des elektronischen Stromverteilers (120) entsprechend der Anweisung von dem Mikrocontroller (130) einzustellen; und
einen Sicherheits-Schaltkreis (115) zum Erkennen einer Fehlfunktion in dem Mikrocontroller (130) und/oder dem elektronischen Stromverteiler (120),
wobei der Treiberschaltkreis (111, 112) eines jeden Kanals (101, 102) ausgebildet ist, bei einer erkannten Fehlfunktion in dem Mikrocontroller (130) und/oder dem Stromverteiler (120) den Zustand des elektronischen Schalters (121, 122) des entsprechenden Kanals (101, 102) des elektronischen Stromverteilers (120) entsprechend einem kanalspezifisch vorkonfigurierten Sicherheitszustand einzustellen.

2. Elektronischer Sicherungsschaltkreis (110) nach Anspruch 1,
wobei der Treiberschaltkreis (111, 112, 113, 114) eines entsprechenden Kanals (101, 102, 103, 104) des elektronischen Stromverteilers (120) ausgebildet ist, einen MOSFET Transistor (221, 222, 223, 224, 225) des entsprechenden Kanals (111, 112, 113, 114) anzusteuern.

3. Elektronischer Sicherungsschaltkreis (110) nach Anspruch 1 oder 2,
wobei der Treiberschaltkreis (111) eines ersten Kanals (101) des elektronischen Stromverteilers (120) ausgebildet ist, einen MOSFET Transistor (221) eines ersten Typs anzusteuern; und
wobei der Treiberschaltkreis (112) eines zweiten Kanals (102) des elektronischen Stromverteilers (120) ausgebildet ist, einen MOSFET Transistor (222) eines zweiten Typs anzusteuern.

4. Elektronischer Sicherungsschaltkreis (110) nach einem der vorstehenden Ansprüche,
wobei der Treiberschaltkreis (111) eines ersten Kanals (101) des elektronischen Stromverteilers (120) ausgebildet ist, einen ersten MOSFET Transistor (221) anzusteuern, der für einen ersten Leitungsquerschnitt einer elektrischen Leitung des elektronischen Stromverteilers (120) spezifiziert ist; und
wobei der Treiberschaltkreis (112) eines zweiten Kanals (102) des elektronischen Stromverteilers (120) ausgebildet ist, einen zweiten MOSFET Transistor (222) anzusteuern, der für einen zweiten Leitungsquerschnitt einer elektrischen Leitung des elektronischen Stromverteilers (120) spezifiziert ist.

5. Elektronischer Sicherungsschaltkreis (110) nach einem der vorstehenden Ansprüche,
wobei der Sicherheits-Schaltkreis (115) einen Watchdog-Schaltkreis (115f) umfasst, der ausgebildet ist, eine Fehlfunktion des Mikrocontrollers (130) basierend auf einem Empfang von Lebenszeichen-Signalen über die Mikrocontroller-Schnittstelle (116) in vorgegebenen zeitlichen Abständen zu erkennen.

6. Elektronischer Sicherungsschaltkreis (110) nach einem der vorstehenden Ansprüche,
wobei der Treiberschaltkreis (111, 112) des entsprechenden Kanals (101, 102) ausgebildet ist, eine transiente Unterspannung an einer Spannungsversorgungsklemme (123, 124) des entsprechenden Kanals (101, 102) basierend auf einer Erfassung einer Klemmenspannung an der Spannungsversorgungsklemme (123, 124) zu bestimmen; und
wobei der Sicherheits-Schaltkreis (115) ausgebildet ist, den elektronischen Schalter (121, 122) des entsprechenden Kanals (101, 102) abzuschalten, wenn die Klemmenspannung einen ersten Abschaltschwellwert unterschreitet.

7. Elektronischer Sicherungsschaltkreis (110) nach Anspruch 6,
wobei der Treiberschaltkreis (111, 112) des entsprechenden Kanals (101, 102) ausgebildet ist, eine stationäre Unterspannung an der Spannungsversorgungsklemme (123, 124) des entsprechenden Kanals (101, 102), die sich basierend auf einer zeitlichen Mittelung der erfassten Klemmenspannung bestimmt, von dem Mikrocontroller (130) über die Mikrocontroller-Schnittstelle (116) zu empfangen; und
wobei der Treiberschaltkreis (111, 112) des entsprechenden Kanals (101, 102) ausgebildet ist, den MOSFET Transistor (221, 222) abzuschalten, wenn die über die Mikrocontroller-Schnittstelle (116) erhaltene stationäre Unterspannung einen zweiten Abschaltschwellwert überschreitet.

8. Elektronischer Sicherungsschaltkreis (110) nach Anspruch 7,
wobei der Treiberschaltkreis (111, 112) des entsprechenden Kanals (101, 102) ausgebildet ist, die erfasste Klemmenspannung an der Spannungsversorgungsklemme (123, 124) zur Bestimmung der stationären Unterspannung über die Mikrocontroller-Schnittstelle (116) an den Mikrocontroller (130) zu übertragen.

9. Elektronischer Sicherungsschaltkreis (110) nach einem der vorstehenden Ansprüche,
wobei der elektronische Schalter (121, 122) des entsprechenden Kanals (101, 102) einen MOSFET Transistor (221, 222) umfasst;
wobei der Treiberschaltkreis (111, 112) des entsprechenden Kanals (101, 102) ausgebildet ist, eine transiente Überlast in dem entsprechenden Kanal basierend auf einer Erfassung einer Differenzspannung eines Drain Anschlusses (U_D) und eines Source Anschlusses (U_S) des MOSFET Transistors (221, 222) zu bestimmen; und
wobei der Sicherheits-Schaltkreis (115) ausgebildet ist, den MOSFET Transistor (221, 222) abzuschalten, wenn die Differenzspannung einen dritten Abschaltschwellwert überschreitet.

10. Elektronischer Sicherungsschaltkreis (110) nach Anspruch 9,
wobei der Treiberschaltkreis (111, 112) des entsprechenden Kanals (101, 102) ausgebildet ist, einen stationären Überstrom des entsprechenden Kanals, der sich basierend auf einem RDSON Modell des MOSFET Transistors (221, 222) bestimmt, von dem Mikrocontroller (130) über die Mikrocontroller-Schnittstelle (116) zu empfangen; und
wobei der Treiberschaltkreis (111, 112) des entsprechenden Kanals (101, 102) ausgebildet ist, den MOSFET Transistor (221, 222) abzuschalten, wenn der über die Mikrocontroller-Schnittstelle (116) erhaltene stationäre Überstrom einen vierten Abschaltschwellwert überschreitet.

11. Elektronischer Sicherungsschaltkreis (110) nach Anspruch 10,
wobei der Treiberschaltkreis (111, 112) des entsprechenden Kanals (101, 102) ausgebildet ist, die Differenzspannung des Drain Anschlusses (U_D) und des Source Anschlusses (U_S) des MOSFET Transistors (221, 222) zur Bestimmung des RDSON Modells über die Mikrocontroller-Schnittstelle (116) an den Mikrocontroller (130) zu übertragen.

12. Elektronischer Sicherungsschaltkreis (110) nach Anspruch 10 oder 11,
wobei der Treiberschaltkreis (111, 112) des entsprechenden Kanals (101, 102) ausgebildet ist, eine Gehäusetemperatur des MOSFET Transistors (221, 222) des entsprechenden Kanals (101, 102) zu erfassen und zur Bestimmung des RDSON Modells über die Mikrocontroller-Schnittstelle (116) an den Mikrocontroller (130) zu übertragen.

13. Elektronischer Sicherungsschaltkreis (110) nach einem der Ansprüche 6 bis 9,
mit zumindest einem Register (115c) zum Speichern der Abschaltschwellwerte;
wobei der elektronische Sicherungsschaltkreis (110) ausgebildet ist, die Abschaltschwellwerte über die Mikrocontroller-Schnittstelle (116) zu empfangen und in dem zumindest einem Register (115c) zu speichern.

14. Elektronischer Sicherungsschaltkreis (110) nach einem der vorstehenden Ansprüche, mit:
einem digitalen Zustandsautomaten (115b) zum Speichern der Zustände der elektronischen Schalter (121, 122) der jeweiligen Kanäle (101, 102) des elektronischen Stromverteilers (120);
wobei der Treiberschaltkreis (111, 112) des entsprechenden Kanals (101, 102) ausgebildet ist, bei einer Einstellung des Zustands des elektronischen Schalters (121, 122) des entsprechenden Kanals (101, 102) den digitalen Zustandsautomaten (115b) entsprechend einzustellen.

15. Verfahren (400) zum Absichern eines mehrkanaligen elektronischen Stromverteilers, wobei das Verfahren folgendes umfasst:
Ansteuern (401) eines elektronischen Schalters eines entsprechenden Kanals des elektronischen Stromverteilers, einen bestimmten Zustand einzunehmen, durch einen Treiberschaltkreis für jeden Kanal des elektronischen Stromverteilers;
Empfangen (402) einer Anweisung zum Einstellen des Zustands des elektronischen Schalters eines entsprechenden Kanals des elektronischen Stromverteilers, von einem Mikrocontroller über eine Mikrocontroller-Schnittstelle;
Einstellen (403) des Zustands des elektronischen Schalters des entsprechenden Kanals des elektronischen Stromverteilers, durch den Treiberschaltkreis des entsprechenden Kanals, entsprechend der Anweisung des Mikrocontrollers;
Erkennen (404) einer Fehlfunktion in dem Mikrocontroller und/oder dem elektronischen Stromverteiler durch einen Sicherheits-Schaltkreis; und
Einstellen (405) des Zustands des elektronischen Schalters des entsprechenden Kanals des elektronischen Stromverteilers, durch den Treiberschaltkreis eines jeden Kanals, entsprechend einem kanalspezifisch vorkonfigurierten Sicherheitszustand, wenn eine Fehlfunktion in dem Mikrocontroller und/oder dem Stromverteiler erkannt ist.
